# EUROPEAN PATENT SPECIFICATION

(11) **EP 2 621 248 B1**
(45) Date of publication and mention of the grant of the patent: **19.08.2015**
(21) Application number: 13152476.1
(22) Date of filing: 24.01.2013
(51) Int. Cl.: H05B 37/02, G04C 11/04, G04C 23/00, G04F 10/04, H03K 5/153

(54) **A light system with synchronized effects.**
Lichtsystem mit synchronisierten Effekten
Système d'éclairage à effets synchronisés

(30) Priority: 26.01.2012 IT MC20120006
(43) Date of publication of application: 31.07.2013
(73) Proprietor: Si.Gi. Impianti Elettrici di Silenzi Gianluca e Simone S.N.C., 63831 Rapagnano (FM) (IT)
(72) Inventor: Silenzi, Gianluca, 63831 Rapagnano (FM) (IT); Silenzi, Simone, 63831 Rapagnano (FM) (IT)
(74) Representative: Baldi, Claudio

(56) References cited:
- US-A1- 2008 157 939
- US-A1- 2008 297 068

## Description

The present patent application for industrial invention relates to a light system with synchronized effects, adapted to generate multiple light effects, movements and possibly chromatic effects.

Various types of intermittent light systems are known on the market.

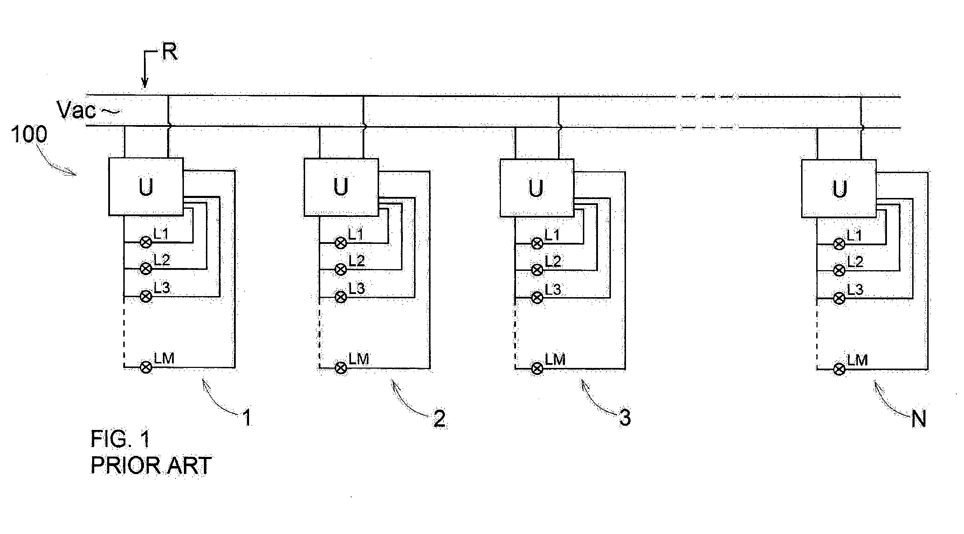

Fig. 1 shows an intermittent light system according to the prior art, generally indicated with reference numeral (100).

The system (100) comprises a plurality of sets of lights (1, 2, 3, ... N). Each set of lights comprises an electronic control unit (U) connected to a plurality of light sources (L1, L2, L3, ... LM).

Each control unit (U) is connected to the electrical network (R) to take electrical power (Vac) from the network and power the light sources.

Moreover, each control unit (U) is provided with an oscillator, such as a quartz oscillator, to power the light sources (L1, ... LM) according to a predefined sequence related with the frequency of the oscillator of the control unit (U).

In such a case, the control units (U) of the sets of lights (1, ... N) are independent and therefore the sets of lights will have independent effects and cannot be synchronized. After switching-on the various sets, generally after a few minutes, the time constants of the various electronic components of the control units (U) are no longer respected and each set of lights (1, ... N) lights up with an unpredictable random effect.

Elements that are identical or correspond to the ones described above are indicated hereinafter with the same reference numbers, omitting a detailed description.

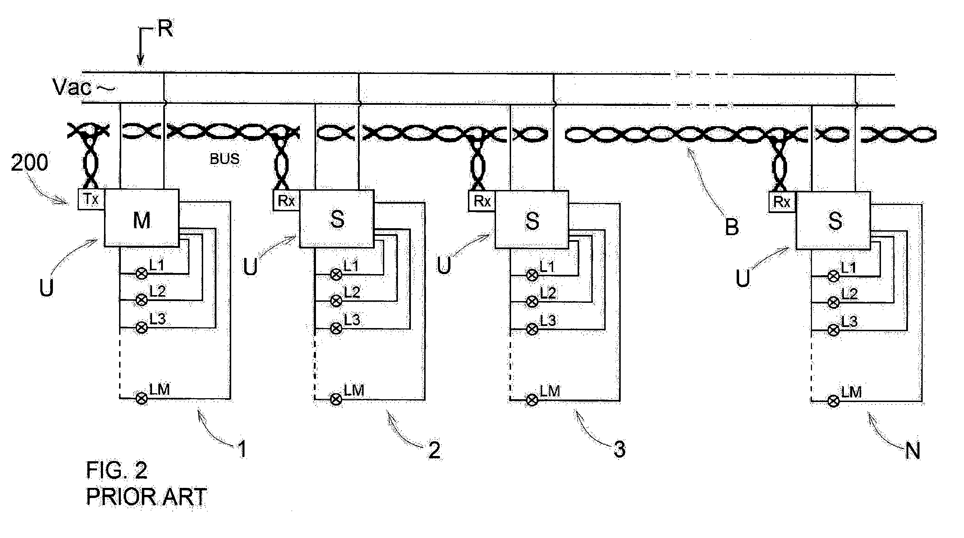

Fig. 2 shows a synchronized intermittent light system (200) according to the prior art.

The system (200) provides for at least one control unit (U) working as master (M) and other control units (U) working as slave (S). The master (M) is provided with a transmitter (Tx) and slaves (S) are provided with receivers (Rx).

The transmitter (Tx) and receivers (Rx) are connected by means of a data transmission bus (B). The bus (B) can be an electrical twisted cable, such as a twisted pair. In such a way, the master (M) transmits a sequence of impulses over the bus (B) that is indicative of the switching-on sequence of the light sources (L1, ... LM) of the sets (1, ... N). Slaves (S) receive the impulses transmitted over the bus (B) and switch-on the light sources accordingly.

Said system (200) is very complicated because of the difficulties related with passing the bus (B) in a pre-existing electrical installation. Moreover, also the wiring of the control units (U) is complicated because, in addition to be connected to the network (R), said control units must be connected to the bus (B), thus doubling the wiring operations.

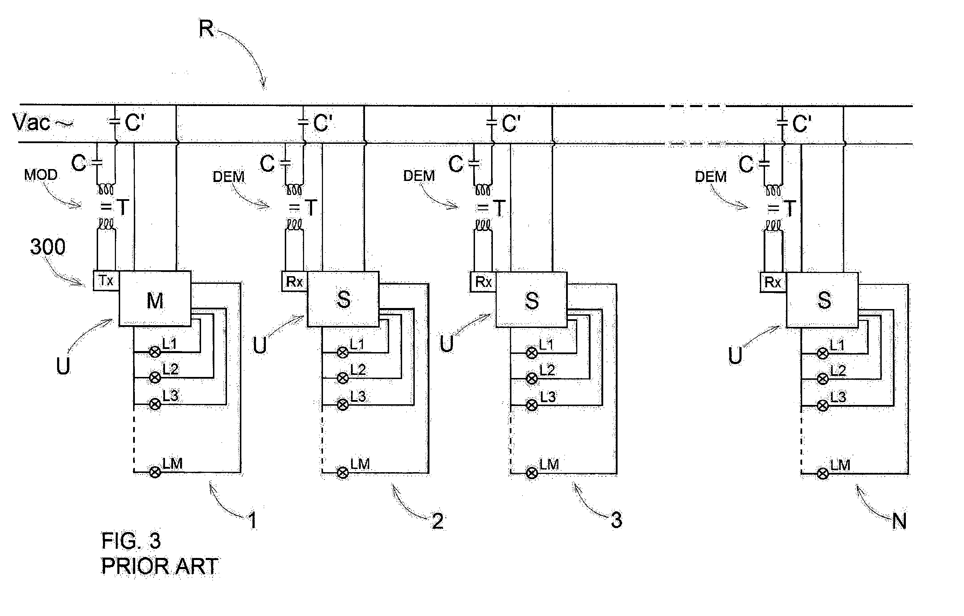

The aforementioned drawbacks are partially solved by the synchronized intermittent light system (300) of known type, shown in Fig. 3.

The system (300) provides for synchronization of the control units (U) of the various sets of lights (1, ... N) by means of conveyed waves transmitted over the electrical power network (R).

In such a case, the transmitter (Tx) of the master (M) is coupled with the network (R) by means of a modulator (MOD) adapted to modulate a data signal in order to send it over the network. Instead, the receivers (Rx) of the slaves (S) are coupled with the network (R) by means of a demodulator (DEM) adapted to demodulate the data signal present in the network.

The modulator (MOD) and demodulators (DEM) of the various units (U) can be realized by means of transformers (T) and decoupling capacity (C, C').

The system (300) is impaired by high costs for the provision of modulator and demodulators. Moreover, the system (300) is subject to high interference, especially if other modems are connected to the electrical network (R).

In order to solve wiring problems, a system (400) with synchronized intermittent lights controlled by means of radio communication is known.

In such a case, the transmitter of the master is provided with a transmitting antenna (AT) adapted to transmit a data signal modulated in radio frequency and the receivers of the slaves are provided with a receiving antenna (AR) adapted to receive the data signal transmitted by the master (M).

Likewise, said system (400) is very expensive because of the provision of radio frequency transreceivers and antennas and is not free from radio interference.

US2008/0297068 describes a control system of an entertainment system comprising at least one light source to generate a variable light output and at least one controller coupled to the light source to control the variable light output based on a number of interruptions of power supplied to an apparatus over a pre-determined time period.

The purpose of the present invention is to eliminate the drawbacks of the prior art, by devising a light system with synchronized effects that is versatile, practical, inexpensive and simple to install and use.

These purposes have been achieved according to the invention, with the characteristics claimed in independent claim 1.

Advantageous embodiments appear from the dependent claims.

The light system of the invention is adapted to be connected to an electrical network with alternating-current mains voltage. The system comprises a plurality of sets of lights, wherein each set of lights comprises an electronic control unit connected to a plurality of light sources. Each control unit is connected to the electrical network in such manner to switch on and off said light sources.

Each control unit comprises:
- a zero crossing detector adapted to detect all zero crossings of electrical voltage; and
- a processor adapted to count said zero crossings of voltage and accordingly control the switching-on and switching-off of said light sources.

The system comprises a programmable interface connected to the electrical network, upstream at least one set of lights, to interrupt the electrical voltage, in such manner to generate micro-interruptions of a few microseconds sent to the control units in discordance with the mains frequency in order to vary the switching-on and switching-off sequence of said light sources.

The advantages of the system of the invention are evident because all control units are synchronized with the mains frequency. The system of the invention has higher immunity to interference than the known systems and avoids complicated wiring and use of expensive devices, such as transreceivers, modulators and demodulators.

Further characteristics of the invention will appear clearer from the detailed description below, which refers to merely illustrative, not limiting, embodiments, illustrated in the attached drawings, wherein:
Fig. 1 is a block diagram of an intermittent light system according to the prior art;
Fig. 2 is a block diagram of a system of intermittent lights synchronized by means of a bus according to the prior art;
Fig. 3 is a block diagram of a system of intermittent lights synchronized by means of conveyed waves according to the prior art;

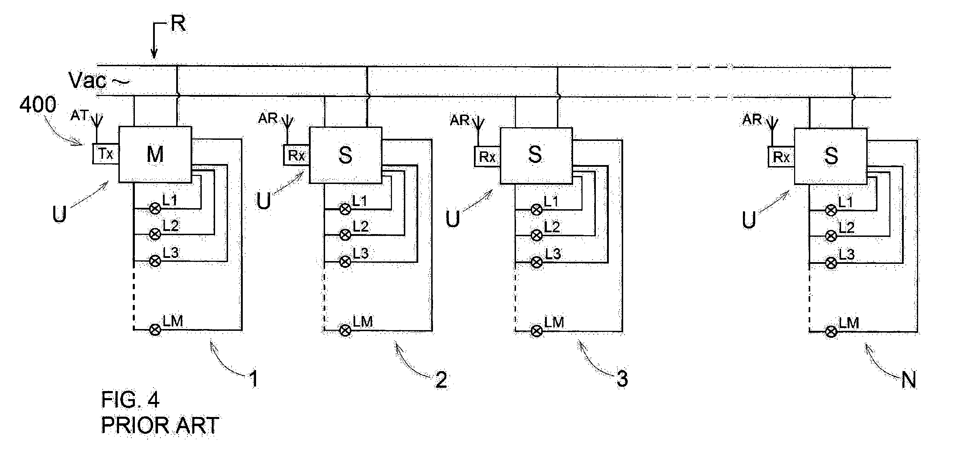

Fig. 4 is a block diagram of a system of intermittent lights synchronized by means of radio waves according to the prior art;
Fig. 5 is a block diagram of a system of lights with synchronized effects, wherein lights are synchronized by means of the mains frequency according to the invention;
Fig. 6 is a block diagram showing in detail the control unit of a set of light sources of the system of Fig. 5;
Fig. 7 is a diagram showing the transmission of signals that control the operation of the system of Fig. 5,
Fig. 8 is a block diagram of an improved embodiment of the synchronized intermittent light system of Fig. 5 that includes the transmission of micro-interruptions to program the parameters of each single unit; and
Fig. 9 comprises two charts showing the voltage trend on the network at the input of the control units and the command signal generated by the control units.

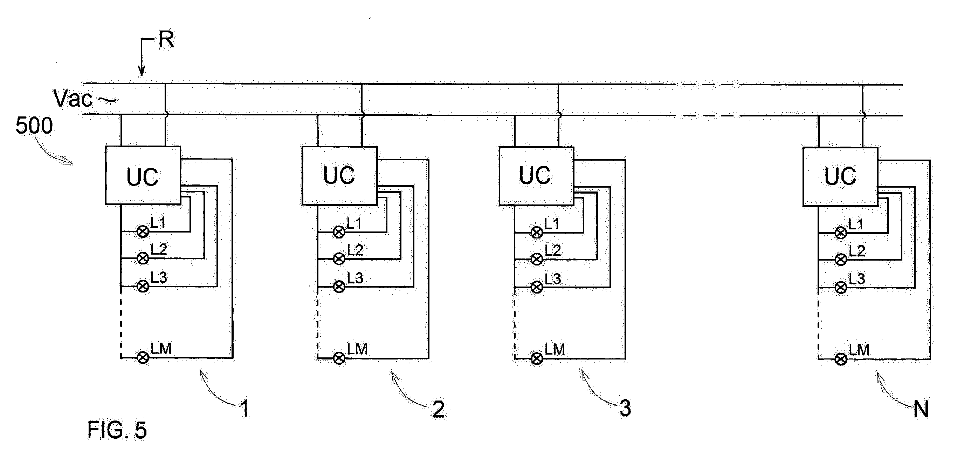

Now referring to Figs. 5-7, the synchronized intermittent light system according to the invention is described, being generally indicated with reference numeral (500).

The system (500) comprises a plurality of sets of lights (1, 2, 3, ... N). Each set of lights comprises an electronic control unit (UC) connected to a plurality of light sources (L1, L2, L3, ... LM).

Each control unit (UC) is connected to the electrical network (R) to power the light sources.

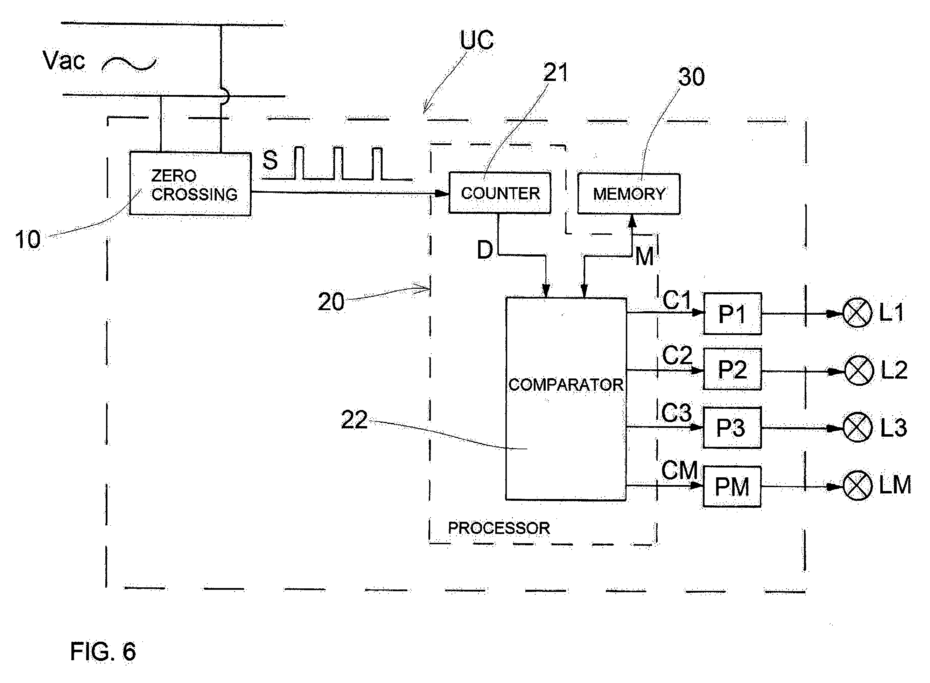

Referring to Fig. 6, the control unit (UC) comprises a zero crossing detector (10) adapted to detect all zero crossings of mains alternating voltage (Vac) that, as it is known, has a sinusoidal trend with one positive half-wave and one negative half-wave; therefore the zero crossing detector (10) will detect a zero crossing every time the mains voltage (Vac) switches from positive (+) to negative (-) and vice versa.

Although in the following description specific reference is made to a zero crossing detectors, the invention extends to any equivalent circuit adapted to detect, for example, the maximum, minimum or intermediate points of the sinusoid of mains voltage (Vac) with frequency proportional to the mains frequency.

As it is known, the zero crossing detector (10) can be made with an operational amplifier or with MOS transistor, Field-Effect Transistor (FET) or Bipolar Junction Transistor (BJT).

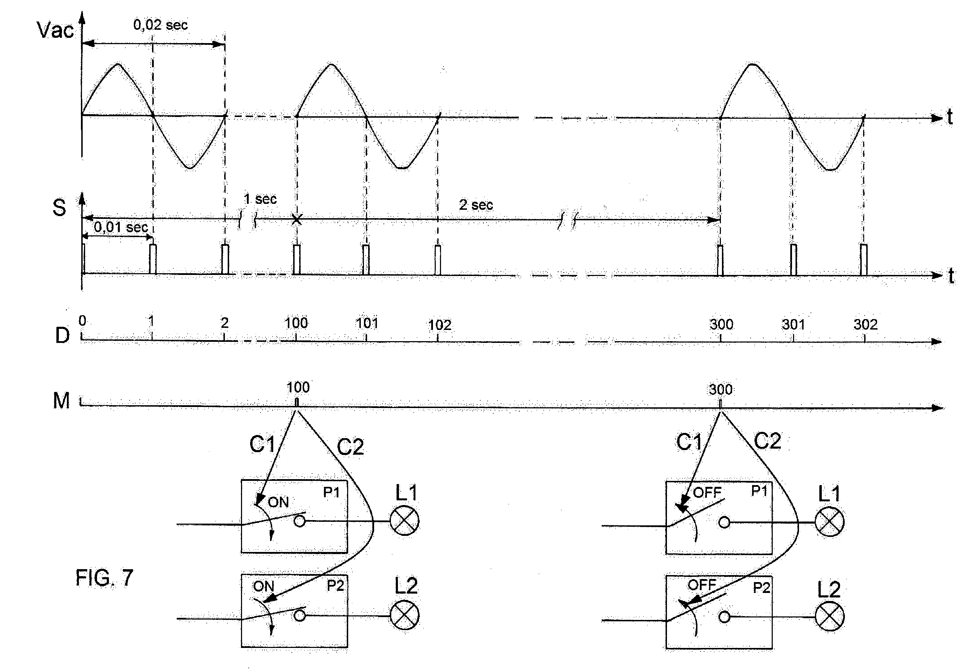

Also referring to Fig. 7, said zero crossing detector (10) generates a train of impulses (S) in output, wherein each impulse is in correspondence of the zero crossing of the sinusoid of the mains voltage (Vac) crosses zero. Therefore, the frequency of the impulses of the train of impulses (S) emitted by the detector (10) is double than the mains frequency.

So, if the mains voltage (Vac) is a sinusoid with 50 Hz frequency, i.e. a period of 0.02 seconds, the train of impulses (S) will have a frequency of 100 Hz and a period of 0.01 second.

The train of impulses (S) is sent to a processor (20) of the control unit (UC) that comprises a counter (21). The counter (21) counts the impulses of the train of impulses (S) and generates in output a numerical signal (D) corresponding to a sequence of numbers based on the counted impulses.

The control unit (UC) comprises a memory (30) wherein a program is stored containing numerical values (M) indicative of the various light sources (L1, L2 ... LM) to be switched on, and the switching-on and switching-off sequence of said light sources. These numerical values (M) are predefined in each memory (30).

The numerical signal (D) from the counter (21) and the numerical values (M) stored in the memory (30) are sent to a comparator (22) incorporated in the processor (20) of the control unit (UC). The comparator (22) compares the numbers of the numerical signal (D) from the counter (21) with the numerical values (M) stored in the memory (30). When the numbers of the numerical signal (D) are identical to the numerical values (M) of the memory, the comparator (22) sends control signals (C1, C2, C3, ... CM) to corresponding power units (P1, P2, P3, ... PM) that control the light sources (L1, ... LM).

The power units (P1, ... PM) can be triac or equivalent devices mounted in the control unit (UC). The light sources (L1, ... LM) can be chromatic or non-chromatic lamps, LEDs, preferably RGB LEDs in order to generate different colors according to their switch-on and switch-off combinations.

Fig. 7 shows an example in which one second after the switching-on of the system (500) the user intends to switch on the two light sources (L1, L2) of the first set of lights (1).

In such a case, numbers 100 and 300 are stored in the memory (30) of the control unit (UC). Consequently, after the counter (21) has counted 100 impulses starting from the switching-on of the system, i.e. after one second has elapsed, the comparator (22) sends control signals of ON type (C1, C2) to the two power units (P1, P2) that can be considered as normally open switches that are then closed to power the light sources (L1, L2).

After the counter (21) has counted 300 impulses starting from the switching-on of the system, i.e. after two seconds have elapsed from the switching-on of the light sources (L1, L2), the comparator (22) sends control signals of OFF type (C1, C2) to the two power units (P1, P2) opening the switches in such manner to switch-off the light sources (L1, L2).

It must be considered that all sets of lights (1, ... N) are synchronized with the frequency of the network (R) by means of the control units (UC), and therefore the system (500) allows for obtaining a perfect synchronization of the various sets of lights, completely free from interference and avoiding complicated wiring of the control units (UC) and the use of expensive devices, such as transreceivers, modulators and demodulators.

According to the embodiment of Fig. 5, the switching-on and switching-off sequences of the various light sources of the various sets of lights are strictly linked to the pre-defined numerical values (M) stored in the memories (30) of the corresponding control units (UC).

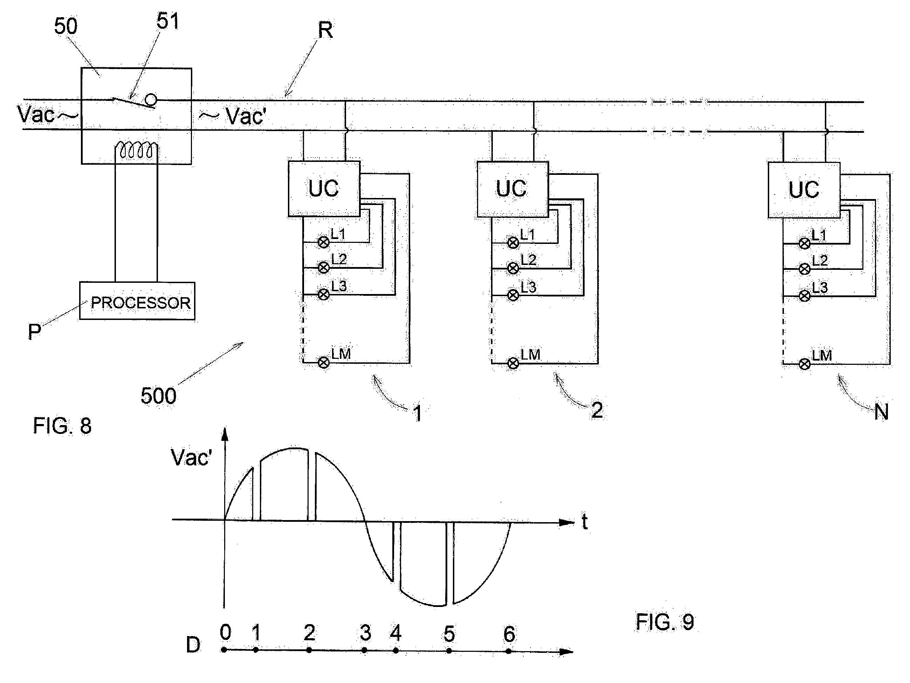

Fig. 8 shows a variant of the system (500) that allows for programming the switching-on and switching-off intervals of the light sources of the various sets of lights, in such manner to obtain different light effects.

In such a case, an interface (50) is connected to the electrical network (R) upstream at least one set of lights (1, ...N).

The interface (50) comprises a controlled switch (51) adapted to generate very short interruptions (zero crossings) of the power voltage. The switch (51) is normally closed and can be controlled by a processor (P) that can be programmed by the operator.

Such power interruptions last a few microseconds (micro-interruptions) and are sent to the control units (UC) in discordance with the mains frequency. Fig. 9 shows an example in which four micro-interruptions are sent during a period of the sinusoid of the mains voltage, and consequently the counter (21) counts six zero crossings instead of two.

Consequently, because of said micro-interruptions, the processor (20) of the control unit sees a more rapid counting with respect to the mains frequency. Therefore, the micro-interruptions indicate the processor (20) that it is intended to vary the program contained in the memory (30).

According to the micro-interruptions counted by the counter (21), the processor (20) of the control unit suspends the execution of the program of the memory (30), switches to a programming mode and re-programs the numerical values contained in the memory (30). Therefore, the memory (30) of each control unit must be of writable type in order to be reprogrammed by means of the micro-interruptions generated by the interface (50).

Numerous variations and modifications can be made to the present embodiments of the invention, within the reach of an expert of the field, while still falling within the scope of the invention described in the enclosed claims.

## Claims

1. An intermittent light system (500) adapted to be connected to an electrical network (R) with alternating-current mains voltage (Vac), said system (500) comprising a plurality of sets of lights (1, 2, 3, ... N), wherein each set of lights comprises an electronic control unit (UC) connected to a plurality of light sources (L1, L2, L3, ... LM), each electronic control unit (UC) being connected to the electrical network (R) to take voltage (Vac) from the network and power the light sources, in such manner to switch said light sources on and off,
each electronic control unit (UC) comprises:
- a zero crossing detector (10) adapted to detect all zero crossings of the mains voltage (Vac), and
- a processor (20) adapted to count said zero crossings of voltage (Vac) and accordingly control the switching-on and switching-off of said light sources (L1, ... LM),
**characterized by** the fact that said intermittent light system comprises a programmable interface (50) connected to the electrical network (R), upstream at least one set of lights, to interrupt voltage, in such manner to generate micro-interruptions of a few microseconds that are sent to the control units (UC) in discordance with the mains frequency, in such manner to vary the switching-on and switching-off sequence of said light sources.

2. A system (500) according to claim 1, **characterized by** the fact that said zero crossing detector (10) generates a train of impulses (S) wherein each impulse is emitted in the instant when voltage (Vac) crosses zero.

3. A system (500) according to claim 1 or 2, **characterized by** the fact that each control unit (UC) comprises a memory (30) to store numerical values (M) indicative of a switching-on and switching-off sequence of the light sources (L1, ... LM) of each set of lights (1, ... N).

4. A system (500) according to claim 2 or 3, **characterized by** the fact that said processor (20) of each control unit comprises a counter (21) to count the impulses of the train of impulses (S) coming out from the zero crossing detector (10) in such manner to generate a numerical signal (D) indicative of the counted impulse number.

5. A system (500) according to claim 4 when dependent upon claim 3, **characterized by** the fact that said processor (20) of each control unit comprises a comparator (22) to compare the numerical signal (D) from the counter (21) with the numerical values (M) stored in the memory (30).

6. A system (500) according to claim 5, **characterized by** the fact that each control unit (UC) comprises a plurality of power units (P1, ... PM) to power said light sources, said power units (P1, ... PM) being connected to the comparator (22) to receive control signals (C1, ... CM) when the numbers of the numerical signal (D) from the counter (21) are identical to the numerical values (M) stored in the memory (30).

7. A system (500) according to any one of claims 3 to 6, **characterized by** the fact that said memory (30) of the control unit is a writable memory that is reprogrammed when said processor (20) of the control unit detects the presence of said micro-interruptions on voltage.

8. A system (500) according to claim 7, **characterized by** the fact that it comprises a processor (P) connected to said programmable interface (50) to allow the operator to program said memory (30) of the control unit according to said micro-interruptions generated by said programmable interface (50).

9. A system (500) according to any one of the preceding claims, **characterized by** the fact that said light sources (L1, ... LM) are RGB LEDs.

## Patentansprüche

1. System (500) mit intermittierenden Lichtern, das geeignet ist, an ein Stromnetz (R) mit einer Wechselstrom-Netzspannung (Vac) angeschlossen zu werden, dieses System (500) umfassend mehrere Gruppen von Lichtern (1, 2, 3, ... N), wobei jede Gruppe von Lichtern eine elektronische Steuereinheit (UC) umfasst, an die mehrere Lichtquellen (L1, L2, L3, ... LM) angeschlossen sind, wobei jede elektronische Steuereinheit (UC) jeweils an das Stromnetz (R) angeschlossen ist, um die Stromspannung (Vac) vom Netz zu entnehmen und die Lichtquellen derart zu versorgen, dass die Lichtquellen ein- und ausgeschaltet werden,
jede elektronische Steuereinheit (UC) umfasst:
- einen Nulldurchgangsdetektor (10), der geeignet ist, alle Nulldurchgänge der Netzspannung (Vac) zu erfassen, und
- einen Prozessor (20), der geeignet ist, diese Nulldurchgänge der Netzspannung (Vac) zu zählen und die Ein- und Ausschaltung der Lichtquellen (L1, ... LM) entsprechend zu steuern,
**dadurch gekennzeichnet, dass** das System mit intermittierenden Lichtern eine programmierbare Schnittstelle (50) umfasst, die mindestens einer Gruppe von Lichtern vorgelagert an das Stromnetz (R) angeschlossen ist, um die elektrische Versorgungsspannung derart zu unterbrechen, dass Mikrounterbrechungen in der Größenordnung von einigen Mikrosekunden erzeugt werden, die in Abweichung von der Netzfrequenz an die Steuereinheit (UC) gesendet werden, um die Ein- und Ausschaltsequenz der Lichtquellen abzuwandeln.

2. System (500) nach Anspruch 1, **dadurch gekennzeichnet, dass** der Nulldurchgangsdetektor (10) einen Impulszug (S) erzeugt, wobei jeder Impuls in dem Moment gesendet wird, in dem die Netzspannung (Vac) die Nulllinie kreuzt.

3. System (500) nach Anspruch 1 oder 2, **dadurch gekennzeichnet, dass** jede Steuereinheit (UC) einen Speicher (30) umfasst, in dem die numerischen Werte (M) gespeichert sind, die auf eine Ein- und Ausschaltfrequenz der verschiedenen Lichtquellen (L1, ... LM) einer jeden Gruppe von Lichtern (1, ... N) hinweisen.

4. System (500) nach Anspruch 2 oder 3, **dadurch gekennzeichnet, dass** der Prozessor (20) einer jeden Steuereinheit einen Zähler (21) umfasst, der die Impulse des vom Nulldurchgangsdetektor (10) ausgehenden Impulszugs (S) zählt, um ein numerisches Signal (D) zu senden, das auf die gezählte Impulszahl hinweist.

5. System (500) nach Anspruch 4, wenn abhängig von Anspruch 3, **dadurch gekennzeichnet, dass** der Prozessor (20) einer jeden Steuereinheit einen Zähler (22) umfasst, der das vom Zähler (21) ausgegebene numerische Signal (D) mit den numerischen Werten (M) vergleicht, die im Speicher (30) gespeichert sind.

6. System (500) nach Anspruch 5, **dadurch gekennzeichnet, dass** jede Steuereinheit (UC) mehrere Versorgungseinheiten (P1, ... PM) umfasst, um die jeweiligen Lichtquellen zu versorgen, wobei die Versorgungseinheiten (P1, ... PM) an den Zähler (22) angeschlossen sind, um Steuersignale (C1, ... CM) zu empfangen, wenn die Nummern des vom Zähler (21) ausgegebenen numerischen Signals (D) gleich wie die im Speicher (30) gespeicherten numerischen Werte (M) sind.

7. System (500) nach einem beliebigen der Ansprüche von 3 bis 6, **dadurch gekennzeichnet, dass** der Speicher (30) der Steuereinheit ein beschreibbarer Speicher ist, der neu programmiert wird, wenn der Prozessor (20) der Steuereinheit das Vorliegen von Mikrounterbrechungen der Versorgungsspannung feststellt.

8. System (500) nach Anspruch 7, **dadurch gekennzeichnet, dass** es einen Prozessor (P) umfasst, der an die programmierbare Schnittstelle (50) angeschlossen ist, um es einem Bediener zu ermöglichen, den Speicher (30) der Steuereinheit entsprechend den Mikrounterbrechungen zu programmieren, die von der programmierbaren Schnittstelle (50) erzeugt werden.

9. System (500) nach einem beliebigen der vorstehenden Ansprüche, **dadurch gekennzeichnet, dass** die Lichtquellen (L1, ... LM) RGB-LEDs sind.

## Revendications

1. Système (500) d'éclairage à intermittence apte à être branché à un réseau électrique (R) ayant une tension de réseau (Vac) en courant alterné, ledit système (500) comprenant plusieurs groupes de lumières (1, 2, 3, ... N), où chaque groupe de lumières intègre un module électronique de contrôle (UC) auquel sont connectées une pluralité de sources lumineuses (L1, L2, L3, ... LM), chaque module électronique de contrôle (UC) étant branché au réseau électrique (R) pour prélever la tension électrique (Vac) du réseau et alimenter les sources lumineuses de manière à obtenir la mise sous/hors tension des dites sources lumineuses,
chaque module électronique de contrôle (UC) comprenant :
- un capteur de passage par zéro (10) apte à détecter tous les passages par zéro de la tension électrique (Vac) du réseau, et
- un processeur (20) apte à compter lesdits passages par zéro de la tension électrique (Vac) du réseau et conformément commander la mise sous/hors tension des dites sources lumineuses (L1, ... LM),
**caractérisé en ce que** ledit système d'éclairage à intermittence intègre une interface programmable (50) branchée au réseau électrique (R) en amont d'au moins un groupe de lumières pour couper la tension électrique d'alimentation, de manière à générer des micro-interruptions de l'ordre de quelques microsecondes adressées au module de contrôle (UC) en discordance avec la fréquence de réseau, afin de varier la séquence de mise sous/hors tension des dites sources lumineuses.

2. Système (500) selon la revendication 1, **caractérisé en ce que** ledit capteur de passage par zéro (10) émet en sortie une série d'impulsions (S) où chaque impulsion est émise à l'instant où la tension électrique de réseau (Vac) passe par zéro.

3. Système (500) selon la revendication 1 ou 2, **caractérisé en ce que** chaque module de contrôle (UC) intègre une mémoire (30) dans laquelle sont enregistrées des valeurs numériques (M), indicatives d'une séquence de mise sous tension et mise hors tension des diverses sources lumineuses (L1, ... LM) de chaque groupe de lumières (1, ... N).

4. Système (500) selon la revendication 2 ou 3, **caractérisé en ce que** ledit processeur (20) de chaque module de contrôle intègre un compteur (21) pour compter les impulsions de la série d'impulsions (S) en sortie du capteur de passage par zéro (10) de manière à émettre en sortie un signal numérique (D) indicatif du nombre d'impulsions comptées.

5. Système (500) selon la revendication 4 lorsqu'elle dépend de la revendication 3, **caractérisé en ce que** ledit processeur (20) de chaque module de contrôle intègre un comparateur (22) qui compare le signal numérique (D) en sortie du compteur (21) avec les valeurs numériques (M) enregistrées dans la mémoire (30).

6. Système (500) selon la revendication 5, **caractérisé en ce que** chaque module de contrôle (UC) intègre plusieurs unités de puissance (P1, ... PM) pour alimenter les respectives sources lumineuses, lesdites unités de puissance (P1, ... PM) étant connectées au comparateur (22) pour recevoir des signaux de commande (C1, ... CM) lorsque les chiffres du signal numérique (D) en sortie du compteur (21) sont identiques aux valeurs numériques (M) enregistrées dans la mémoire (30).

7. Système (500) selon l'une quelconque des revendications de 3 à 6, **caractérisé en ce que** ladite mémoire (30) du module de contrôle est une mémoire du type inscriptible qui est reprogrammée lorsque ledit processeur (20) du module de contrôle détecte la présence des dites micro-interruptions sur la tension d'alimentation.

8. Système (500) selon la revendication 7, **caractérisé en ce qu'**il intègre un processeur (P) connecté à ladite interface programmable (50) pour permettre à un opérateur de programmer ladite mémoire (30) du module de contrôle conformément aux dites micro-interruptions générées par ladite interface programmable (50).

9. Système (500) selon l'une quelconque des revendications précédentes, **caractérisé en ce que** lesdites sources lumineuses (L1, ... LM) sont des Diodes du type RGB.
